# EUROPEAN PATENT SPECIFICATION

(11) **EP 4 447 480 B1**
(45) Date of publication and mention of the grant of the patent: **22.04.2026**
(21) Application number: 24162714.0
(22) Date of filing: 11.03.2024
(51) Int. Cl.: H04Q 9/00

(54) **BATTERY SYSTEM AND MONITORING METHOD OF BATTERY SYSTEM**
BATTERIESYSTEM UND ÜBERWACHUNGSVERFAHREN DES BATTERIESYSTEMS
SYSTÈME DE BATTERIE ET PROCÉDÉ DE SURVEILLANCE DE SYSTÈME DE BATTERIE

(30) Priority: 14.04.2023 KR 20230049486
(43) Date of publication of application: 16.10.2024
(73) Proprietor: Samsung SDI Co., Ltd., Yongin-si, Gyeonggi-do 17084 (KR)
(72) Inventor: JEON, Inbeom, 17084 Yongin-si (KR); MUN, Seongjin, 17084 Yongin-si (KR); CHUNG, Mooil, 17084 Yongin-si (KR); JEON, Peelsik, 17084 Yongin-si (KR)
(74) Representative: Marks & Clerk LLP

(56) References cited:
- US-A1- 2012 013 201
- US-A1- 2020 381 926

## Description

### BACKGROUND

### 1. Field

The present disclosure relates to a battery system and a monitoring method of a battery system.

### 2. Description of the Related Art

Research and development on secondary batteries has recently been actively conducted. As referred to herein, a secondary battery is a battery that may be repeatedly charged and discharged, and may include a Ni/Cd battery, a Ni/MH battery, a lithium ion battery, or the like. The lithium ion battery has an advantage of having much higher energy density than the Ni/Cd battery or the Ni/MH battery. The lithium ion battery may be manufactured in a small size and light weight for use as a power source for a mobile device. Particularly, since the lithium ion battery may be used as a power source for an electric vehicle, it is attracting attention as a next-generation energy storage medium.

The secondary battery is generally used as a battery module in which a plurality of battery cells are connected in series and/or in parallel. A battery module manager (BMM) may monitor the battery module, and may communicate with a battery module system (BMS). Errors in communication between the BMM and the BMS may occur due to noise signals. In cases where the communication state between the BMM and BMS is not monitored, a communication abnormality may be continuously present.

US2020/381926A1 and US2012013201A1 provide disclosures relating to battery system management.

### SUMMARY

Embodiments are directed to a battery system in which a battery management system (BMS) receives a signal from a battery module manager (BMM) and transmits a reset signal to control the BMM to resume communication within the battery system, based on the received signal.

Embodiments of the present disclosure may provide a battery system and a monitoring method of a battery system that monitors communication errors in the battery system.

Embodiments of the present disclosure may also provide a battery system and a monitoring method of a battery system that resets an abnormal operation of the battery system at an optimal timing.

A battery system according to embodiments includes: a battery module that includes one or more battery cells and is configured to be charged and discharged; a battery module manager (BMM) that monitors a state of the battery module and controls the battery module; and a battery management system (BMS) configured to receive a signal from the battery module manager and transmit a reset signal that controls the battery module manager to resume communication within the battery system based on the received signal.

The battery module manager may include: a sensing portion for obtaining state data related to a state of the battery module from the battery module; a controller that controls a communication portion for communicating with the battery management system; the controller can control the communication portion to transmit a signal to the battery management system in response to a signal received from the battery management system and changes an operating state of the battery module manager according to the signal received from the battery management system. The battery module manager may thus comprise the aforementioned communication portion.

The battery module manager may receive a data signal from the battery management system during a first time interval, the controller may control the communication portion to transmit, to the battery management system in response to the data signal during the first time interval, a first state signal indicating a state in which the battery module manager communicates with the battery management system, and based on the data signal received from the battery management system, the controller checks a stop bit of data and controls the communication portion to transmit, to the battery management system during a second time interval, a second state signal indicating that reception of the data signal is stopped. For example, the controller controls the communication portion to transmit the second state signal responsive to a positive detection of the stop bit. In general, in the discussion below, a reference to "checking" a bit or a signal may be interpreted as a positive detection of that bit or signal.

The controller may be configured to determine whether the second state signal is transmitted, and may control the communication portion to transmit, to the battery management system during a third time interval if the second state signal is not transmitted, an interrupt flag indicating an error in the second state signal.

The battery management system may be configured to transmit a latch signal to the battery module manager based on the received interrupt flag, and the controller may check the latch signal and may change an operation mode of the battery module manager to a latch mode in which communication between the battery module manager and the battery management system is stopped.

After the battery management system receives the interrupt flag, the battery management system may determine whether a reference time that is a predetermined time has elapsed, and may transmit the reset signal to the battery module manager to release the latch mode.

The reference time may include a time during which a noise signal is applied.

An operation of the battery module manager or the battery management system may be controlled based on a signal applied from a controller external to the battery system, referred to herein as an upper controller.

A monitoring method of a battery system, according to embodiments of the disclosure, include: monitoring, by a battery module manager (BMM), a state of a battery module that includes one or more battery cells and is configured to be charged and discharged and to control the battery module; receiving, by a battery management system (BMS), a signal from the battery module manager; and transmitting, by the BMS to the BMM, a reset signal to control the battery module manager to resume communication with the battery management system based on the received signal.

The monitoring method further includes receiving, by the battery module manager, a data signal from the battery management system during a first time interval; transmitting, by the battery module manager to the battery management system, a first state signal indicating a state in which the battery module manager communicates with the battery management system in response to the data signal during the first time interval; and checking, by the battery module manager, a stop bit of data based on the data signal received from the battery management system and controlling a communication portion of the battery module manager to transmit, to the battery management system during a second time interval overlapping a portion of the first time interval, a second state signal indicating that reception of the data signal is stopped.

The monitoring method may further include: determining, by the battery module manager, whether the second state signal is transmitted; and transmitting, by the battery module manager to the battery management system during a third time interval, in accordance with determining that the second state signal is not transmitted, an interrupt flag indicating an error in the second state signal.

The monitoring method may further include: transmitting, by the battery management system, a latch signal to the battery module manager based on the interrupt flag received by the battery management system; and checking, by the battery module manager, the latch signal to change an operation mode of the battery module manager to a latch mode in which communication between the battery module manager and the battery management system is stopped.

The monitoring method may further include: determining, by the battery management system, whether a reference time that is a predetermined time has elapsed after the battery management system receives the interrupt flag; and transmitting, by the battery management system in accordance with determining that the reference time has elapsed, the reset signal to the battery module manager to release the latch mode.

The reference time may include a time during which a noise signal is applied.

According to the battery system and the monitoring method of the battery system of the embodiments, communication between a battery module manager (BMM) and a battery module system (BMS) may be efficiently resumed without extra cost. At least some of the above and other features of the invention are set out in the claims.

### BRIEF DESCRIPTION OF THE DRAWINGS

Features will become apparent to those of skill in the art by describing in detail embodiments with reference to the attached drawings in which:
FIG. 1 is a configuration diagram schematically showing a battery system according to embodiments of the present disclosure.
FIG. 2 is a graph schematically illustrating signals transmitted and received by a battery module manager (BMM) and a battery management system (BMS) in normal operation, in accordance with embodiments of the disclosure.
FIG. 3 is a graph schematically illustrating signals transmitted and received by the BMM and BMS in the case of a communication error occurring in the battery system, in accordance with further embodiments of the disclosure.
FIG. 4 is a graph schematically illustrating signals transmitted and received by the BMM and BMS in a case where communication monitoring of the battery system is performed, in accordance with further embodiments of the disclosure.
FIG. 5 is a flowchart schematically illustrating a portion of a communication monitoring method according to embodiments of the disclosure.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey example implementations to those skilled in the art.

Like reference numerals refer to like elements throughout.

Expressions such as "1^{st}", "2^{nd}", "first", "second", and the like used in various embodiments may be used to refer to various constituent elements regardless of the order and/or the priority, but the above constituent elements should not be restricted to the above expressions. For instance, the first constituent element may be named the second constituent element, and vice versa, without departing from the scope of the present disclosure.

The terms used in the specification are intended to describe certain embodiments only, and should by no means restrict the scope of another embodiment. Unless clearly used otherwise, expressions in a singular form include a meaning of a plural form.

All the terms used herein, which include technical or scientific terms, may have the same meaning that is generally understood by a person skilled in the art. It will be further understood that terms, which are defined in a dictionary and commonly used, should also be interpreted as is customary in the relevant related art and not in an idealized or overly formal meaning unless expressly defined in the specification. In some cases, even if terms are those which are defined in the specification, they may not be interpreted to exclude embodiments of the present disclosure.

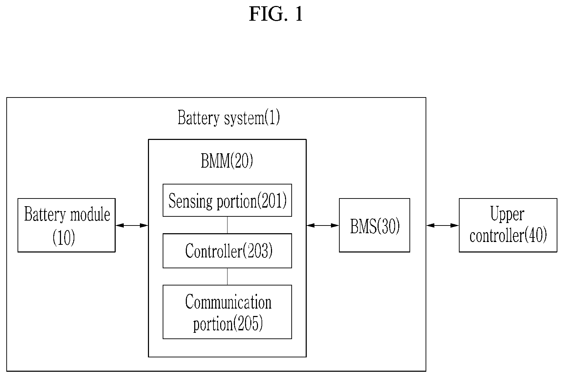

FIG. 1 is a configuration diagram schematically showing a battery system 1, according to embodiments of the present disclosure.

As shown in FIG. 1, the battery system 1 may include a battery module 10 including one or more battery cells and capable of charging and discharging; a battery module manager (BMM) 20 that monitors a voltage, a current, a temperature, or the like of the battery module 10 and controls and manages it to prevent overcharge, overdischarge, or the like; and a battery management system (BMS) 30 that receives a signal from the BMM 20 and takes an appropriate action for the BMM based on the received signal.

The battery module 10 may include battery cells connected in series and/or in parallel. The battery module may supply electric power to external circuits outside of the battery system 1.

The BMM 20 may be connected to the battery module 10 to monitor a state of the battery module 10. The BMM 20 may measure or calculate a voltage or a current of a gate, a source, a drain, or the like of a semiconductor switching element in order to monitor the voltage, the current, the temperature, or the like of the battery module 10. For example, the voltage, the current, the temperature, or the like of the battery module 10 may be measured using a sensor provided adjacent to the semiconductor switching element. The BMM 20 may be an interface that receives measured values of various parameters described above, and may include a plurality of terminals, a circuit connected to the terminals to process received values, or the like. In some embodiments, the BMM 20 may control on/off of a metal oxide semiconductor FET (MOSFET).

For example, the BMM 20 may include a sensing portion (or a sensing unit) 201, a controller (a control portion or a control unit) 203, and a communication portion (or a communication unit) 205. The sensing portion 201 may obtain state data related to a state of the battery module 10 from the battery module 10. For example, the sensing portion 201 may measure the voltage, the current, the temperature, or the like of the battery module 10.

The controller 203 may receive the state data related to the battery module 10 from the sensing portion 201. The controller 203 may detect (or sense) an error occurring in the battery module 10 based on the state data. The controller 203 may control the communication portion 205 so that the communication portion 205 transmits a signal to the BMS 30 in response to a data signal received from the BMS 30. If an error occurs in communication between the controller 203 and the BMS 30 (for example, due to noise or the like), the controller 203 may detect the error, and may transmit a signal related to the error to the BMS 30. In some embodiments, the controller 203 may change an operating state according to a signal received from the BMS 30. In a particular embodiment, the controller 203 may include a micro controller unit (MCU).

The communication portion 205 may transmit and receive information or the signal related to the error to the BMS 30 under control of the controller 203. For example, the communication portion 205 and the BMS 30 may communicate with each other through a low voltage (LV) wire.

The BMM 20 may be connected to the BMS 30 so that operation of the BMM 20 is controlled based on a signal applied from the BMS 30. The BMS 30 may monitor a state of a battery pack including one or more battery modules 10 and the BMM 20. The BMS 30 may monitor a voltage, a current, a temperature, or the like of the battery pack. The BMS 30 may transmit a data signal to the BMM 20. The BMS 30 may monitor an operating state of the BMM 20 based on a signal received from the BMM 20.

The battery system 1 may be connected to an external controller, also referred to herein as upper controller 40. An operation of the BMM 20 or the BMS 30 may be controlled based on a signal applied from the upper controller 40. For example, the upper controller 40 may receive state data related to the state of the battery module 10 from the BMS 30, and may monitor the battery system 1. For example, the BMS 30 and the upper controller 40 may communicate with each other through a controller area network (CAN) bus. The upper controller 40 may include an electronic control unit (ECU).

Hereinafter, a method for monitoring the operating state of the BMM 20 through communication between the BMM 20 and the BMS 30 will be described.

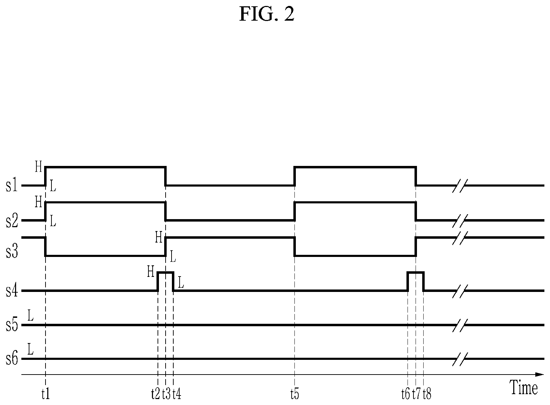

FIG. 2 is a graph schematically illustrating signals transmitted and received by a battery module manager (BMM) and a battery management system (BMS) in normal operation of battery system 1, in accordance with embodiments of the disclosure. In FIG. 2, the horizontal axis of the graph represents time, and various signals s1 - s6 are shown on the vertical axis.

Referring to FIG. 2, during the time period t1 to t3, the BMS 30 may transmit data to the BMM 20. For example, during the time period t1 to t3, the BMS 30 may transmit a data signal s1 at an enable level H to the BMM 20.

In some embodiments, during the time period t1 to t3, the BMM 20 may transmit a first state signal s2 at an enable level H to the BMS 30. The first state signal s2 at the enable level H may indicate a state in which the BMM 20 is communicating with the BMS 30. For example, the first state signal s2 may be a signal related to data received from the BMS 30. During the time period t1 to t3, the controller 203 may control the communication portion 205 to transmit the first state signal s2 at the enable level H to the BMS 30 as a response to the received data signal s1.

During the time period t1 to t3, the BMM 20 may transmit a second state signal s3 at a disable level L to the BMS 30. The second state signal s3 at the disable level L may indicate a state in which the communication between the BMM 20 and the BMS 30 is not interrupted. For example, if the first state signal s2 is transmitted at the enable level H during the time period t1 to t3, the controller 205 may control the communication portion 205 to transmit the second state signal s3 at the disable level L to the BMS 30.

The BMM 20 checks a stop bit of data based on the received data signal s1. The stop bit is a predetermined bit indicating that the data is the last data. For example, the controller 203 checks the stop bit of the data based on the received data signal s1. If the stop bit is checked as positive (i.e. positively detected), the BMM 20 transmits a third state signal s4 at an enable level H to the BMS 30 during the time period t2 to t4. The third state signal s4 at the enable level H indicates data reception interruption. For example, if the stop bit is checked as positive, the controller 203 controls the communication portion 205 to transmit the third state signal s4 at the enable level H to the BMS 30 during the time period t2 to t4.

If the third state signal s4 is normally transmitted, the BMM 20 may transmit an interrupt flag s5 at a disable level L to the BMS 30. The interrupt flag s5 at the disable level L may indicate that no error has occurred in the state signals s2, s3, and s4. For example, if the third state signal s4 is normally transmitted, the controller 203 may control the communication portion 205 to transmit the interrupt flag s5 at the disable level L to the BMS 30.

In some embodiments, if the BMS 30 receives the interrupt flag s5 at the disable level L, the BMS 30 may transmit a latch signal s6 at a disable level L to the BMM 20. If the interrupt flag s5 at the disable level L is transmitted, the above-described communication procedure may be followed. For example, during the time period t3 to t5, the BMM 20 may transmit the first state signal s2 at the disable level L to the BMS 30. During the time period t5 to t7, the BMS 30 may transmit the data signal s1 at the enable level H to the BMM 20, and the BMM 20 may transmit the first state signal s2 at the enable level H to the BMS 30. For example, if the BMM 20 checks (i.e. positively detects) a specific bit based on the received data signal s1, the BMM 20 may transmit the third state signal s4 at the enable level H to the BMS 30 during the time period t6 to t8.

Hereinafter, a case in which the battery system 1 of the embodiments abnormally operates due to noise or the like will be described.

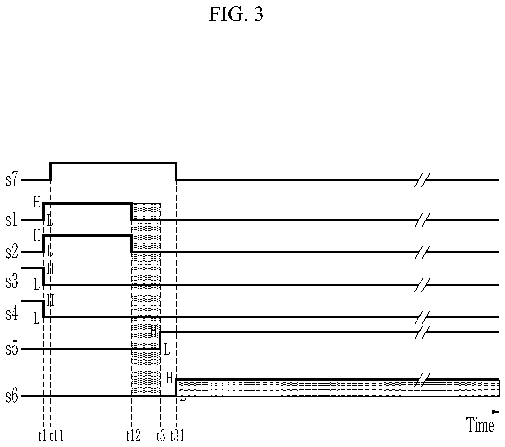

FIG. 3 is a graph schematically illustrating signals transmitted and received by the BMM and BMS in the case of a communication error occurring in the battery system 1 (that is, abnormal operation). In FIG. 3, the horizontal axis of the graph represents time, and various signals s1-s7 are shown on the vertical axis. Times t1 and t3 of FIG. 3 may correspond to the times t1 and t3 of FIG. 2.

Referring to FIG. 3, at a time t11 after the time t1 at which the BMM 20 receives the data signal s1, a noise signal s7 may be applied to the BMM 20. Due to the noise signal s7, the BMM 20 may stop receiving the data signal s1 at a time t12 instead of the time t3. Therefore, a communication error may occur during the time period t12 to t3, in contrast to a case where the battery system 1 normally operates.

In some embodiments, referring to FIG. 3, during times t11 to t31, the noise signal s7 may be applied to the BMM 20. For example, the noise signal s7 may be applied to the LV wire so that an error may occur in operation of the communication portion 205 due to the noise signal s7. Due to the noise signal s7, the BMS 30 may transmit the data signal s1 at the enable level H to the BMM 20 during times t1 to t12, and may transmit the data signal s1 at a disable level L to the BMM 20 during the time period t12 to t3.

In some embodiments, during the time period t1 to t12, the BMM 20 may transmit the first state signal s2 at the enable level H to the BMS 30. For example, during the time period t1 to t12, the controller 203 may control the communication portion 205 to transmit the first state signal s2 at the enable level H to the BMS 30.

In some embodiments, during the time period t1 to t12, the BMM 20 may transmit the second state signal s3 at the disable level L to the BMS 30. For example, the controller 203 may control the communication portion 205 to transmit the second state signal s3 at the disable level L to the BMS 30 during the times t1 to t12 during which the first state signal s2 is transmitted.

Due to a communication error (communication abnormality) caused by the noise signal s7, the BMM 20 may not check (i.e. may not positively detect, or detect a lack of, or detect a given value indicating a negative) the stop bit. For example, the controller 203 may not check (i.e. not positively detect, or detect a lack of, or detect a given value indicating a negative) the stop bit. In some embodiments, the BMM 20 may transmit the third state signal s4 at a disable level L to the BMS 30. For example, if the stop bit is not checked (i.e. not positively detected, or detected as being absent, or as having a given value indicating a negative), the controller 203 may control the communication portion 205 to transmit the third state signal s4 at the disable level L to the BMS 30 during the time period t12 to t3.

If the third state signal s4 is transmitted at the disable level L, the BMM 20 may transmit the interrupt flag s5 at an enable level H to the BMS 30 at the time t3. For example, the controller 203 may determine a level at which the third state signal s4 is transmitted. If the third state signal s4 at the disable level L is transmitted, the controller 203 may control the communication portion 205 to transmit the interrupt flag s5 at the enable level H to the BMS 30 at the time t3.

If the BMS 30 receives the interrupt flag s5 at the enable level H, the BMS 30 may transmit the latch signal s6 at an enable level H to the BMM 20. If the BMM 20 receives the latch signal s6 at the enable level H, it may operate in a latch mode. The latch mode may mean a mode in which the communication between the BMM 20 and the BMS 30 is interrupted (or stopped). For example, if the controller 203 checks the latch signal s6 at the enable level H, the controller 203 may change an operation mode of the BMM 20 to the latch mode. If the BMM 20 is in the latch mode, a series of communication procedures described with reference to FIG. 2 may be interrupted (or stopped). In some embodiments, although application of the noise signal s7 is stopped thereafter, communications of the battery system 1 may not proceed normally.

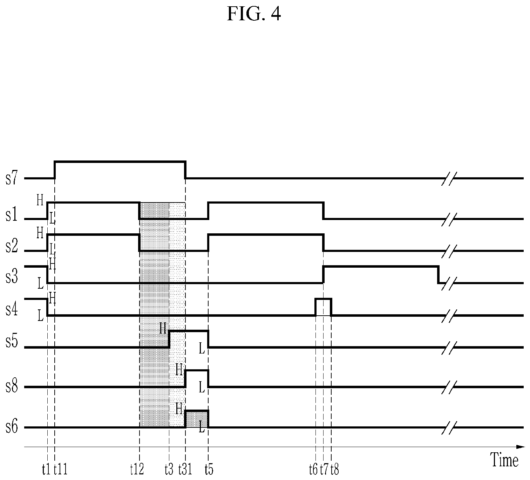

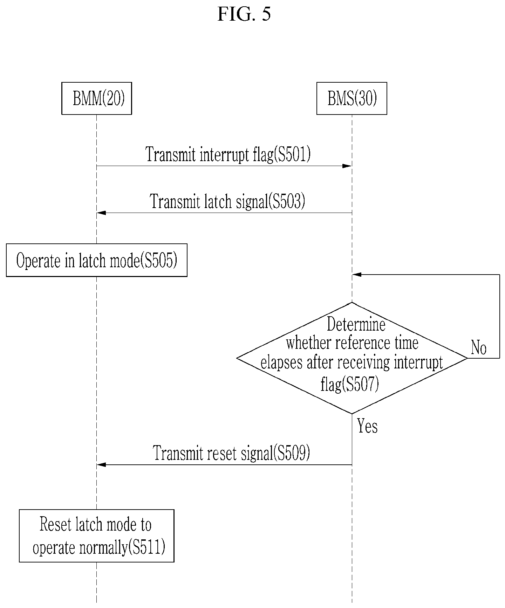

Hereafter, a communication monitoring method employed if the battery system 1 abnormally operates will be described with reference to FIG. 4 and FIG. 5.

FIG. 4 is a graph schematically illustrating signals transmitted and received by the BMM and BMS in a case where communication monitoring of the battery system of the embodiments is performed, and FIG. 5 is a flowchart schematically illustrating a portion of the communication monitoring method according to embodiments. Referring to FIG. 4, the horizontal axis of the graph represents time, and various signals s1 - s8 are shown on the vertical axis. Times t1, t3, t5, t6, t7, and t8 of FIG. 4 may correspond to the times t1, t3, t5, t6, t7, and t8 of FIG. 2.

Referring to FIG. 4, abnormal operation of the BMM 20 may occur due to the noise signal s7 described with reference to FIG. 3. For example, during the time period t11 to t31, the noise signal s7 may be applied to the BMM 20. The BMS 30 may transmit the data signal s1 at the enable level H to the BMM 20 during the time period t1 to t12 due to the noise signal s7. During the time period t1 to t12, the BMM 20 may transmit the first state signal s2 at the enable level H to the BMS 30, and may transmit the second state signal s3 at the disable level L to the BMS 30; during the time period t12 to t3, the BMM 20 may transmit the third state signal s4 at the disable level L.

In some embodiments, referring to FIGS. 4 and 5, the BMM 20 may transmit the interrupt flag s5 at the enable level H to the BMS 30 (S501). If the BMS 30 receives the interrupt flag s5 at the enable level H, the BMS 30 may transmit the latch signal s6 at the enable level H to the BMM 20 (S503). The BMM 20 may operate in the latch mode according to the received latch signal at the enable level H (S505).

For example, if the third state signal s4 is transmitted at the disable level L during the time period t12 to t3, the controller 203 may control the communication portion 205 to transmit the interrupt flag s5 at the enable level H to the BMS 30 at the time t3. If the BMS 30 receives the interrupt flag s5 at the enable level H, the BMS 30 may transmit the latch signal s6 at the enable level H to the BMM 20 at the time t31. If the controller 203 checks the latch signal s6 at the enable level H, it may change the operation mode to the latch mode. If the BMM 20 is in the latch mode, the series of communication procedures described with reference to FIG. 2 may be interrupted.

After the BMS 30 receives the interrupt flag s5 from the BMM 20, the BMS 30 may determine whether a reference time has elapsed (S507). If it is determined that the reference time has elapsed, the BMS 30 may transmit a reset signal at an enable level H to the BMM 20 (S509), and the BMM 20 may reset the latch mode according to the received reset signal to operate normally (S511). If the BMS 30 determines that the reference time has not elapsed, it may then determine whether the reference time has elapsed.

For example, the reference time may be a predetermined time. In some embodiments, because the noise signal s7 may be applied to the BMM 20 every 2 seconds in a situation such as a bulk current injection (BCI) test, the reference time may be set to 2 seconds. However, the present disclosure is not limited thereto, and the reference time may be a constant time or a variable time, and may be differently set according to a purpose and a situation in which the noise signal s7 is applied. The reset signal s8 may be a signal that controls the BMM 20 to release the latch mode and resume communication between the BMM 20 and the BMS 30.

Referring again to FIG. 4, if the BMS 30 determines that the reference time has elapsed, the BMS 30 may transmit the reset signal s8 at the enable level H to the BMM 20 during the time period t31 to t5. The controller 203 may reset the latch mode at the time t5 according to the received reset signal s8 to operate normally in a state in which communication between the controller 203 and the BMS 30 is possible. For example, unlike a case described above with reference to FIG. 3, the latch mode of the BMM 20 may be maintained only during the time period t31 to t5 after the noise signal s7 is stopped, the data signal s1 may be normally received again, and the above-described series of communication procedures during the time period t5 to t8 may be followed.

According to the battery system 1 and the communication monitoring method of the battery system 1 according to the embodiments described above, a communication abnormality phenomenon of the battery system may be efficiently monitored without additional cost, and an abnormal operation of the battery system may be reset at an optimal timing.

Example embodiments have been disclosed herein, and although specific terms are employed, they are used and are to be interpreted in a generic and descriptive sense only and not for purpose of limitation. **In** some instances, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery system (1), comprising:
a battery module (10) that includes one or more battery cells and is configured to be charged and discharged;
a battery module manager (20), BMM, that is configured to monitor a state of the battery module and control the battery module;
a battery management system (30), BMS, configured to receive a signal from the battery module manager and transmit a reset signal that controls the battery module manager to resume communication within the battery system based on the received signal; **characterized in that**
the BMM is further configured to receive a data signal from the battery management system, check a stop bit of data based on the data signal received from the battery management system, and transmit, to the battery management system, a state signal indicating that reception of the data signal is stopped.

2. The battery system as claimed in claim 1, wherein the battery module manager comprises:
a sensing portion (201) for obtaining state data related to a state of the battery module from the battery module; and
a controller (203) configured to control a communication portion (205) for communicating with the battery management system, wherein the controller is configured to control the communication portion to transmit a signal to the battery management system in response to a signal received from the battery management system and to change an operating state of the battery module manager according to the signal received from the battery management system.

3. The battery system as claimed in claim 2, wherein the battery module manager is configured to receive a data signal from the battery management system during a first time interval, the controller is configured to control the communication portion to transmit, to the battery management system in response to the data signal during the first time interval, a first state signal indicating a state in which the battery module manager communicates with the battery management system, and the controller is configured to, based on the data signal received from the battery management system, check a stop bit of data and control the communication portion to transmit, to the battery management system during a second time interval, a second state signal indicating that reception of the data signal is stopped.

4. The battery system as claimed in claim 3, wherein the controller is configured to determine whether the second state signal is transmitted and to control the communication portion to transmit, to the battery management system during a third time interval if the second state signal is not transmitted, an interrupt flag indicating an error in the second state signal.

5. The battery system as claimed in claim 4, wherein the battery management system is configured to transmit a latch signal to the battery module manager based on the received interrupt flag, and the controller is configured to check the latch signal and change an operation mode of the battery module manager to a latch mode in which communication between the battery module manager and the battery management system is stopped.

6. The battery system as claimed in claim 5, wherein the battery management system is configured to, after the battery management system receives the interrupt flag, determine whether a reference time that is a predetermined time has elapsed and, in accordance with determining that the reference time has elapsed, transmit the reset signal to the battery module manager to release the latch mode.

7. The battery system as claimed in claim 6, wherein the reference time includes a time during which a noise signal is applied.

8. The battery system as claimed in any preceding claim, wherein an operation of the battery module manager or the battery management system is configured to be controlled based on a signal applied from an upper controller external to the battery system.

9. A monitoring method of a battery system (1), comprising:
monitoring, by a battery module manager (20), BMM, a state of a battery module (10) that includes one or more battery cells, wherein the battery module is configured to be charged and discharged and to control the battery module;
receiving, by a battery management system (30), BMS, a signal from the battery module manager, BMM;
transmitting, by the battery management system, BMS, to the battery module manager, BMM, a reset signal to control the battery module manager, BMM, to resume communication with the battery management system, BMS, based on the received signal; **characterized**
**by** the battery module manager, receiving a data signal from the battery management system, checking a stop bit of data based on the data signal received from the battery management system, and transmitting, to the battery management system, a state signal indicating that reception of the data signal is stopped.

10. The monitoring method of a battery system as claimed in claim 9, further comprising:
receiving, by the battery module manager, BMM, a data signal from the battery management system, BMS, during a first time interval;
transmitting, by the battery module manager, BMM, to the battery management system, BMS, a first state signal indicating a state in which the battery module manager, BMM, communicates with the battery management system, BMS, in response to the data signal during the first time interval; and
checking, by the battery module manager, BMM, a stop bit of data based on the data signal received from the battery management system, BMS, and controlling a communication portion (205) of the battery module manager, BMM, to transmit to the battery management system, BMS, during a second time interval overlapping a portion of the first time interval a second state signal indicating that reception of the data signal is stopped.

11. The monitoring method of a battery system as claimed in claim 10, further comprising:
determining, by the battery module manager, BMM, whether the second state signal is transmitted; and
transmitting, by the battery module manager, BMM, to the battery management system, BMS, during a third time interval, in accordance with determining that the second state signal is not transmitted, an interrupt flag indicating an error in the second state signal.

12. The monitoring method of a battery system as claimed in claim 11, wherein the interrupt flag is received by the battery management system, BMS, and further comprising:
transmitting, by the battery management system, BMS, a latch signal to the battery module manager, BMM, based on the interrupt flag; and
checking, by the battery module manager, BMM, the latch signal to change an operation mode of the battery module manager, BMM, to a latch mode in which communication between the battery module manager, BMM, and the battery management system, BMS, is stopped.

13. The monitoring method of a battery system as claimed in claim 12, further comprising:
determining, by the battery management system, BMS, whether a reference time that is a predetermined time has elapsed es after the battery management system, BMS, receives the interrupt flag; and
transmitting, by the battery management system, BMS, in accordance with determining that the reference time has elapsed, the reset signal to the battery module manager, BMM, to release the latch mode.

14. The monitoring method of a battery system as claimed in claim 13, wherein the reference time includes a time during which a noise signal is applied.

## Patentansprüche

1. Batteriesystem (1), das Folgendes umfasst:
ein Batteriemodul (10), das eine oder mehrere Batteriezellen beinhaltet und dazu konfiguriert ist, geladen und entladen zu werden;
einen Batteriemodulmanager (20), BMM, der dazu konfiguriert ist, den Status des Batteriemoduls zu überwachen und das Batteriemodul zu steuern;
ein Batteriemanagementsystem (30), BMS, das dazu konfiguriert ist, ein Signal von dem Batteriemodulmanager zu empfangen und ein Rücksetzsignal zu übertragen, das den Batteriemodulmanager dazu steuert, die Kommunikation innerhalb des Batteriesystems basierend auf dem empfangenen Signal wieder aufzunehmen; **dadurch gekennzeichnet, dass**
das BMM weiter dazu konfiguriert ist, ein Datensignal von dem Batteriemanagementsystem zu empfangen, ein Stoppbit von Daten basierend auf dem Datensignal zu prüfen, das von dem Batteriemanagementsystem empfangenen wird, und ein Statussignal, das angibt, dass der Empfang des Datensignals gestoppt ist, an das Batteriemanagementsystem zu übertragen.

2. Batteriesystem nach Anspruch 1, wobei der Batteriemodulmanager Folgendes umfasst:
einen Abtastabschnitt (201) zum Erhalten von Statusdaten, die einen Status des Batteriemoduls betreffen, aus dem Batteriemodul; und
eine Steuereinheit (203), die dazu konfiguriert ist, einen Kommunikationsabschnitt (205) zum Kommunizieren mit dem Batteriemanagementsystem zu steuern, wobei die Steuereinheit dazu konfiguriert ist, den Kommunikationsabschnitt zum Übertragen eines Signals an das Batteriemanagementsystem als Reaktion auf ein von dem Batteriemanagementsystem empfangenen Signal zu steuern und einen Betriebsstatus des Batteriemodulmanagers gemäß dem von dem Batteriemanagementsystem empfangenen Signal zu ändern.

3. Batteriesystem nach Anspruch 2, wobei der Batteriemodulmanager dazu konfiguriert ist, während eines ersten Zeitintervalls ein Datensignal von dem Batteriemanagementsystem zu empfangen, die Steuereinheit dazu konfiguriert ist, den Kommunikationsabschnitt zu steuern, um an das Batteriemanagementsystem als Reaktion auf das Datensignal während des ersten Zeitintervalls ein erstes Statussignal zu übertragen, das seinen Status angibt, in dem der Batteriemodulmanager mit dem Batteriemanagementsystem in Kommunikation steht, und die Steuereinheit dazu konfiguriert ist, basierend auf dem von dem Batteriemanagementsystem empfangenen Datensignal ein Stoppbit von Daten zu prüfen und den Kommunikationsabschnitt dazu zu steuern, dem Batteriemanagementsystem während eines zweiten Zeitintervalls ein zweites Statussignal zu übertragen, das angibt, dass der Empfang des Datensignals gestoppt ist.

4. Batteriesystem nach Anspruch 3, wobei die Steuereinheit konfiguriert ist, zu bestimmen, ob das zweite Statussignal übertragen wird, und den Kommunikationsabschnitt zu steuern, während eines dritten Zeitintervalls, falls das zweite Statussignal nicht übertragen wird, ein Interrupt-Flag zu übertragen, das einen Fehler in dem zweiten Statussignal angibt.

5. Batteriesystem nach Anspruch 4, wobei das Batteriemanagementsystem dazu konfiguriert ist, basierend auf dem empfangenen Interrupt-Flag ein Latch-Signal an den Batteriemodulmanager zu senden, und die Steuereinheit dazu konfiguriert ist, das Latch-Signal zu prüfen und einen Betriebsmodus des Batteriemodulmanagers in einen Latch-Modus zu ändern, in dem die Kommunikation zwischen dem Batteriemodulmanager und dem Batteriemanagementsystem gestoppt ist.

6. Batteriesystem nach Anspruch 5, wobei das Batteriemanagementsystem dazu konfiguriert ist, nach Empfangen des Interrupt-Flags durch das Batteriemanagementsystem zu bestimmen, ob eine Referenzzeit, die eine vorbestimmte Zeit ist, verstrichen ist, und gemäß dem Bestimmen, dass die Referenzzeit verstrichen ist, das Rücksetzsignal an den Batteriemodulmanager zu übertragen, um den Latch-Modus freizugeben.

7. Batteriesystem nach Anspruch 6, wobei die Referenzzeit eine Zeit beinhaltet, während der ein Rauschsignal angelegt wird.

8. Batteriesystem nach einem vorstehenden Anspruch, wobei ein Betrieb des Batteriemodulmanagers oder des Batteriemanagementsystems dazu konfiguriert ist, basierend auf einem Signal gesteuert zu werden, das von einer übergeordneten, außerhalb des Batteriesystems liegenden Steuereinheit angelegt wird.

9. Überwachungsverfahren für ein Batteriesystem (1), das Folgendes umfasst:
Überwachen, durch einen Batteriemodulmanager (20), BMM, eines Status eines Batteriemoduls (10), das eine oder mehrere Batteriezellen beinhaltet, wobei das Batteriemodul dazu konfiguriert ist, geladen und entladen zu werden, um das Batteriemodul zu steuern;
Empfangen, durch ein Batteriemanagementsystem (30), BMS, eines Signals von dem Batteriemodulmanager, BMM;
Übertragen, durch das Batteriemanagementsystem, BMS, eines Rücksetzsignals an den Batteriemodulmanager, BMM, um den Batteriemodulmanager, BMM, dazu zu steuern, die Kommunikation mit dem Batteriemanagementsystem, BMS, basierend auf dem empfangenen Signal wieder aufzunehmen; **gekennzeichnet dadurch,**
**dass** der Batteriemodulmanager, der ein Datensignal von dem Batteriemanagementsystem empfängt, ein Stoppbit von Daten basierend auf dem von dem Batteriemanagementsystem empfangenen Datensignal prüft und an das Batteriemanagementsystem ein Statussignal überträgt, das angibt, dass der Empfang des Datensignals gestoppt ist.

10. Überwachungsverfahren eines Batteriesystems nach Anspruch 9, das weiter Folgendes umfasst:
Empfangen, durch den Batteriemodulmanager, BMM, eines Datensignals von dem Batteriemanagementsystem, BMS, während eines ersten Zeitintervalls;
Übertragen, durch den Batteriemodulmanager, BMM, an das Batteriemanagementsystem, BMS, eines ersten Statussignals, das einen Status angibt, in dem der Batteriemodulmanager, BMM, mit dem Batteriemanagementsystem, BMS, als Reaktion auf das Datensignal während des ersten Zeitintervalls in Kommunikation steht; und
Prüfen, durch den Batteriemodulmanager, BMM, eines Stoppbits von Daten basierend auf dem von dem Batteriemanagementsystem, BMS, empfangenen Datensignal und Steuern eines Kommunikationsabschnitts (205) des Batteriemodulmanagers, BMM, zum Übertragen eines zweiten Statussignals an das Batteriemanagementsystem, BMS, während eines zweiten Zeitintervalls, das einen Teil des ersten Zeitintervalls überlappt, um anzugeben, dass der Empfang des Datensignals gestoppt ist.

11. Überwachungsverfahren eines Batteriesystems nach Anspruch 10, das weiter Folgendes umfasst:
Bestimmen, durch den Batteriemodulmanager, BMM, ob das zweite Statussignal übertragen wird; und
Übertragen, durch den Batteriemodulmanager, BMM, an das Batteriemanagementsystem, BMS, während eines dritten Zeitintervalls, gemäß dem Bestimmen, dass das zweite Statussignal nicht übertragen wird, eines Interrupt-Flags, das einen Fehler in dem zweiten Statussignal angibt.

12. Überwachungsverfahren eines Batteriesystems nach Anspruch 11, wobei das Interrupt-Flag von dem Batteriemanagementsystem, BMS, empfangen wird und weiter Folgendes umfasst:
Übertragen, durch das Batteriemanagementsystem, BMS, eines Latch-Signals basierend auf dem Interrupt-Flag an den Batteriemodulmanager, BMM; und
Prüfen, durch den Batteriemodulmanager, BMM, des Latch-Signals, um einen Betriebsmodus des Batteriemodulmanagers, BMM, in einen Latch-Modus zu ändern, in dem Kommunikation zwischen dem Batteriemodulmanager, BMM, und dem Batteriemanagementsystem, BMS, gestoppt ist.

13. Überwachungsverfahren eines Batteriesystems nach Anspruch 12, das weiter Folgendes umfasst:
Bestimmen, durch das Batteriemanagementsystem, BMS, ob eine Referenzzeit, die eine vorbestimmte Referenzzeit ist, verstrichen ist, nachdem das Batteriemanagementsystem, BMS, das Interrupt-Flag empfangen hat; und
Übertragen, durch das Batteriemanagementsystem, BMS, gemäß dem Bestimmen, dass die Referenzzeit verstrichen ist, des Rücksetzsignals an den Batteriemodulmanager, BMM, um den Latch-Modus freizugeben.

14. Überwachungsverfahren eines Batteriesystems nach Anspruch 13, wobei die Referenzzeit eine Zeit beinhaltet, während der ein Rauschsignal angelegt wird.

## Revendications

1. Système de batterie (1), comprenant :
un module de batterie (10) qui inclut une ou plusieurs cellules de batterie et qui est configuré pour être chargé et déchargé ;
un gestionnaire de module de batterie (20), BMM, configuré pour surveiller l'état du module de batterie et commander le module de batterie ;
un système de gestion de batterie (30), BMS, configuré pour recevoir un signal du gestionnaire de module de batterie et transmettre un signal de réinitialisation qui commande au gestionnaire de module de batterie de reprendre la communication au sein du système de batterie sur la base du signal reçu ; **caractérisé en ce que**
le BMM est configuré en outre pour recevoir un signal de données du système de gestion de batterie, vérifier un bit d'arrêt de données sur la base du signal de données reçu du système de gestion de batterie et transmettre, au système de gestion de batterie, un signal d'état indiquant que la réception du signal de données est arrêtée.

2. Système de batterie selon la revendication 1, dans lequel le gestionnaire de module de batterie comprend :
une partie de détection (201) pour obtenir des données d'état relatives à l'état du module de batterie à partir du module de batterie ; et
un dispositif de commande (203) configuré pour commander une partie de communication (205) pour communiquer avec le système de gestion de batterie, dans lequel le dispositif de commande est configuré pour commander la partie de communication afin de transmettre un signal au système de gestion de batterie en réponse à un signal reçu du système de gestion de batterie et de modifier un état de fonctionnement du gestionnaire de module de batterie en fonction du signal reçu du système de gestion de batterie.

3. Système de batterie selon la revendication 2, dans lequel le gestionnaire de module de batterie est configuré pour recevoir un signal de données du système de gestion de batterie pendant un premier intervalle de temps, le dispositif de commande est configuré pour commander la partie de communication afin de transmettre, au système de gestion de batterie en réponse au signal de données pendant le premier intervalle de temps, un premier signal d'état indiquant un état dans lequel le gestionnaire de module de batterie communique avec le système de gestion de batterie, et le dispositif de commande est configuré pour, sur la base du signal de données reçu du système de gestion de batterie, vérifier un bit d'arrêt de données et commander la partie de communication afin de transmettre, au système de gestion de batterie pendant un deuxième intervalle de temps, un second signal d'état indiquant que la réception du signal de données est arrêtée.

4. Système de batterie selon la revendication 3, dans lequel le dispositif de commande est configuré pour déterminer si le second signal d'état est transmis et pour commander la partie de communication afin de transmettre, au système de gestion de batterie pendant un troisième intervalle de temps si le second signal d'état n'est pas transmis, un indicateur d'interruption signalant une erreur dans le second signal d'état.

5. Système de batterie selon la revendication 4, dans lequel le système de gestion de batterie est configuré pour transmettre un signal de verrouillage au gestionnaire de module de batterie sur la base de l'indicateur d'interruption reçu, et le dispositif de commande est configuré pour vérifier le signal de verrouillage et modifier un mode de fonctionnement du gestionnaire de module de batterie en un mode de verrouillage dans lequel la communication entre le gestionnaire de module de batterie et le système de gestion de batterie est arrêtée.

6. Système de batterie selon la revendication 5, dans lequel le système de gestion de batterie est configuré pour, après que le système de gestion de batterie a reçu l'indicateur d'interruption, déterminer si un temps de référence qui est un temps prédéterminé s'est écoulé et, en fonction de la détermination que le temps de référence s'est écoulé, transmettre le signal de réinitialisation au gestionnaire de module de batterie pour libérer le mode de verrouillage.

7. Système de batterie selon la revendication 6, dans lequel le temps de référence inclut un temps pendant lequel un signal de bruit est appliqué.

8. Système de batterie selon une quelconque revendication précédente, dans lequel un fonctionnement du gestionnaire de module de batterie ou du système de gestion de batterie est configuré pour être commandé sur la base d'un signal appliqué par un dispositif de commande supérieur externe au système de batterie.

9. Procédé de surveillance d'un système de batterie (1), comprenant :
la surveillance, par un gestionnaire de module de batterie (20), BMM, de l'état d'un module de batterie (10) qui inclut une ou plusieurs cellules de batterie, dans lequel le module de batterie est configuré pour être chargé et déchargé et pour commander le module de batterie ;
la réception, par un système de gestion de batterie (30), BMS, d'un signal du gestionnaire de module de batterie, BMM ;
la transmission, par le système de gestion de batterie, BMS, au gestionnaire de module de batterie, BMM, d'un signal de réinitialisation pour commander au gestionnaire de module de batterie, BMM, de reprendre la communication avec le système de gestion de batterie, BMS, sur la base du signal reçu ; **caractérisé**
**par** le gestionnaire de module de batterie, recevant un signal de données du système de gestion de batterie, vérifiant un bit d'arrêt de données sur la base du signal de données reçu du système de gestion de batterie, et transmettant, au système de gestion de batterie, un signal d'état indiquant que la réception du signal de données est arrêtée.

10. Procédé de surveillance d'un système de batterie selon la revendication 9, comprenant en outre :
la réception, par le gestionnaire de module de batterie, BMM, d'un signal de données du système de gestion de batterie, BMS, pendant un premier intervalle de temps ;
la transmission, par le gestionnaire de module de batterie, BMM, au système de gestion de batterie, BMS, d'un premier signal d'état indiquant un état dans lequel le gestionnaire de module de batterie, BMM, communique avec le système de gestion de batterie, BMS, en réponse au signal de données pendant le premier intervalle de temps ; et
la vérification, par le gestionnaire de module de batterie, BMM, d'un bit d'arrêt de données sur la base du signal de données reçu du système de gestion de batterie, BMS, et la commande d'une partie de communication (205) du gestionnaire de module de batterie, BMM, afin de transmettre au système de gestion de batterie, BMS, pendant un deuxième intervalle de temps chevauchant une partie du premier intervalle de temps, un second signal d'état indiquant que la réception du signal de données est arrêtée.

11. Procédé de surveillance d'un système de batterie selon la revendication 10, comprenant en outre :
la détermination, par le gestionnaire de module de batterie, BMM, permettant de savoir si le second signal d'état est transmis ; et
la transmission, par le gestionnaire de module de batterie, BMM, au système de gestion de batterie, BMS, pendant un troisième intervalle de temps, en fonction de la détermination que le second signal d'état n'est pas transmis, d'un indicateur d'interruption signalant une erreur dans le second signal d'état.

12. Procédé de surveillance d'un système de batterie selon la revendication 11, dans lequel l'indicateur d'interruption est reçu par le système de gestion de batterie, BMS, et comprenant en outre :
la transmission, par le système de gestion de la batterie, BMS, d'un signal de verrouillage au gestionnaire de module de batterie, BMM, sur la base de l'indicateur d'interruption ; et
la vérification, par le gestionnaire de module de batterie, BMM, du signal de verrouillage pour modifier un mode de fonctionnement du gestionnaire de module de batterie, BMM, en un mode de verrouillage dans lequel la communication entre le gestionnaire de module de batterie, BMM, et le système de gestion de batterie, BMS, est arrêtée.

13. Procédé de surveillance d'un système de batterie selon la revendication 12, comprenant en outre :
la détermination, par le système de gestion de la batterie, BMS, permettant de savoir si un temps de référence qui est un temps prédéterminé s'est écoulé après que le système de gestion de la batterie, BMS, a reçu l'indicateur d'interruption ; et
la transmission, par le système de gestion de la batterie, BMS, en fonction de la détermination que le temps de référence s'est écoulé, du signal de réinitialisation au gestionnaire de module de batterie, BMM, pour libérer le mode de verrouillage.

14. Procédé de surveillance d'un système de batterie selon la revendication 13, dans lequel le temps de référence inclut un temps pendant lequel un signal de bruit est appliqué.
